Europäisches Patentamt

European Patent Office

Office européen des brevets

(11) Veröffentlichungsnummer: **0 325 950**
**A1**

## (12) EUROPÄISCHE PATENTANMELDUNG

(21) Anmeldenummer: 89100416.0

(22) Anmeldetag: 11.01.89

(51) Int. Cl.⁴: **H01L 21/60**

(30) Priorität: 28.01.88 DE 3802403

(43) Veröffentlichungstag der Anmeldung:
02.08.89 Patentblatt 89/31

(84) Benannte Vertragsstaaten:
CH DE FR GB IT LI

(71) Anmelder: TELEFUNKEN electronic GmbH
Theresienstrasse 2
D-7100 Heilbronn(DE)

(72) Erfinder: Stehr, Rainer
Pfühlstrasse 25
D-7100 Heilbronn(DE)
Erfinder: Waschler, Eckehard
Lochbergweg 5
D-7103 Schwaigern(DE)

(74) Vertreter: Maute, Hans-Jürgen, Dipl.-Ing.
TELEFUNKEN electronic GmbH
Theresienstrasse 2
D-7100 Heilbronn(DE)

(54) **Halbleiteranordnung mit Polyimidpassivierung.**

(57) Die Erfindung betrifft ein Verfahren zum Herstellen einer Halbleiteranordnung mit mehreren Leitbahnebenen, bei dem auf der letzten Passivierungsschicht eine Metallschicht aufgebracht wird, die dazu dient, auf dieser Metallschicht Metallkontakte herzustellen. Die freiliegende Metallschicht wird anschließend duch Naßätzen entfernt, wodurch durch Löcher und Risse in der letzten Passivierungsschicht die darunterliegende Leitbahn angeätzt oder durchgeätzt werden kann, was zu einer Zerstörung der Halbleiteranordnung führen kann. Das erfindungsgemäße Verfahren besteht darin, eine zusätzliche Passivierungsschicht aus Polyimid auf die letzte Passivierungsschicht aufzubringen, um deren Löcher und Risse aufzufüllen. Diese Polyimidschicht ist beständig gegenüber dem nachfolgenden Ätzprozeß und verhindert somit eine Beschädigung der darunterliegenden Leitbahn.

FIG.2b

## Halbleiteranordnung mit Polyimidpassivierung

Die Erfindung betrifft ein Verfahren zum Herstellen einer Halbleiteranordnung mit mindestens zwei übereinander angeordneten Leitbahnebenen, bei dem nach Herstellung der letzten Leitbahnebene diese mit einer passivierenden Isolationsschicht abgedeckt wird.

Eine solche Halbleiteranordnung mit mehreren Leitbahnebenen weist eine unebene Oberfläche auf. Dies führt nun dazu, daß die zuletzt aufgebrachte, passivierende Isolationsschicht an den Kanten der Erhebungen Risse, Einschnürungen und Unterbrechungen aufweist, wodurch die darunterliegende Leitbahnebene durch nachfolgende Prozesse beschädigt werden kann.

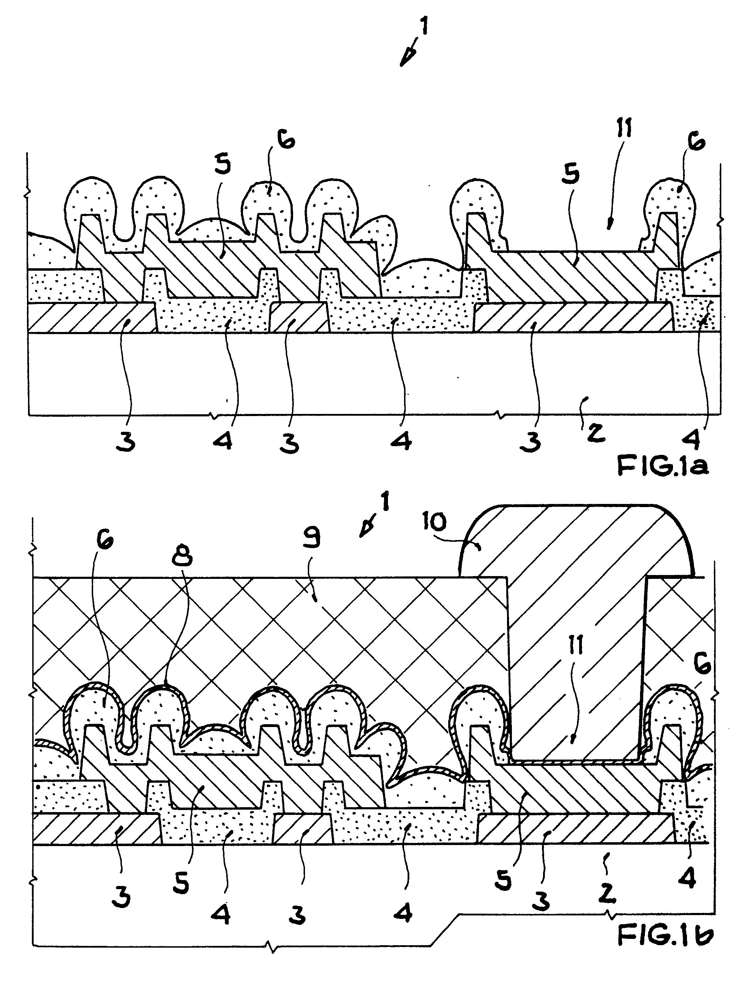

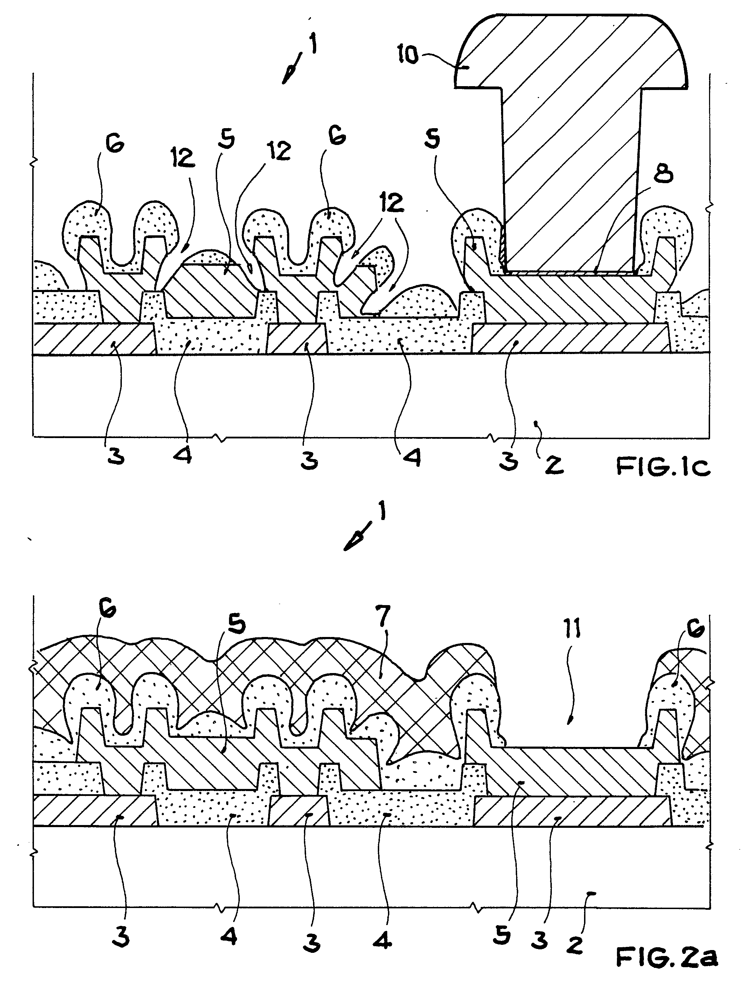

Figur 1a zeigt eine derartige Halbleiteranordnung 1, bei der auf einem Halbleitersubstrat 2 eine erste, zu Leitbahnen 3 ausgebildete Metallisierungsebene und eine die erste und zweite Leitbahnebene 3 bzw. 5 isolierende Zwischenoxidschicht 4 angeordnet ist. Die Unebenheit der Oberfläche der zweiten Leitbahnebene 5 ist die Ursache dafür, daß die auf dieser Oberfläche aufgebrachte, passivierende Isolationsschicht 6 an den Kanten der Erhebungen Einschnürungen und Unterbrechungen aufweist. Um im Kontaktbereich 11 Kontakte 10 herstellen zu können, wird diese Isolationsschicht 6 ganzflächig mit einer dünnen Metallschicht 8 bedeckt, wie es die Figur 1b zeigt. Weiterhin zeigt diese Abbildung den Photolack 9, der die Metallschicht 8 so strukturiert, daß in dem Kontaktbereich 11 durch Galvanisieren ein Metallkontakt 10 aufwachsen kann. Nach dem Entfernen des Photolackes 9 wird die nicht mit Kontakten 10 belegte Metallschicht 8 mittels einem Naßätzverfahren entfernt. Während dieses Ätzverfahren gelangt durch die oben beschriebenen Unterbrechungen und Risse in der passivierenden Isolationsschicht 6 Ätzmittel, beispielsweise Säuren, auf die Leitbahnen 5 der zweiten Metallisierungsebene, wodurch diese Leitbahnen angeätzt oder sogar durchgeätzt werden können, gemäß der Darstellung nach Figur 1c mit den Durchätzungen 12. Diese Beschädigungen oder zweiten Leitbahnebene 5 kann zu Fehlfunktionen oder sogar zur Zerstörung der Halbleiteranordnung führen.

Der Erfindung liegt somit die Aufgabe zugrunde, ein Verfahren zum Herstellen einer Halbleiteranordnung anzugeben, bei dem die zuletzt hergestellte Leitbahnebene durch nachfolgende Ätzprozesse nicht beschädigt wird.

Diese Aufgabe wird bei einem Verfahren der eingangs erwähnten Art nach der Erfindung dadurch gelöst, daß auf die passivierende Isolationsschicht eine Polyimidschicht aufgebracht wird, daß diese Polyimidschicht zur Freilegung von Kontaktbereichen an die letzte Leitbahnebene strukturiert wird, daß danach ganzflächig eine dünne Metallschicht aufgebracht wird, die in den Kontaktbereichen mit Hilfe eines Photolackprozesses und einer nachfolgenden Metallabscheidung zur Bildung von Kontakten verstärkt werden, und daß schließlich die nicht verstärkten Bereiche der dünnen Metallschicht durch Ätzen entfernt werden.

Durch dieses erfindungsgemäße Verfahren wird auf die die letzte Leitbahnebene passivierende Isolationsschicht eine zweite Passivierungsschicht aus Polyimid, vorzugsweise durch Aufschleudern, ganzflächig aufgebracht, wodurch die Unterbrechungen und Risse in der darunterliegenden ersten Isolationsschicht aufgefüllt werden. Diese erfindungsgemäße Maßnahme verhindert daher das Eindringen von Ätzmittel durch die erste Isolationsschicht auf die darunterliegenden Leitbahnen während eines nachfolgenden Ätzprozesses, wodurch diese Leitbahnen nicht angeätzt oder durchgeätzt werden können. Gemäß einer ersten Ausführungsform der Erfindung weist die Polyimidschicht eine Dicke zwischen 1,0 und 1,5 $\mu$m auf.

Die Metallschicht besteht gemäß einer vorteilhaften Ausführungsform der Erfindung aus einer Schichtenfolge Titan-Titanwolfram-Gold, wobei das Titan einen besonders guten elektrischen Kontakt gewährleistet und das Titanwolfram eine Legierungssperre zwischen Aluminium und Gold bildet. Vorzugsweise wird diese Metallschicht durch Sputtern aufgebracht, wobei sich gemäß einer weiteren Ausbildung der Erfindung eine Dicke von ca. 0,5 $\mu$m als vorteilhaft erwies. In einer anderen bevorzugten Ausführungsform der Erfindung werden die Kontakte pilzförmig, als sogenannte "balls" ausgebildet, wodurch die Halbleiteranordnung in einem speziellen Verfahren ausgezeichnet kontaktiert werden kann. Vorzugsweise werden diese Metallkontakte gemäß einer anderen vorteilhaften Weiterbildung der Erfindung aus einer Schichtenfolge Nickel-Gold hergestellt.

Bei einer anderen erfindungsgemäßen Weiterbildung des Verfahrens erfolgt die Herstellung der Metallkontakte durch Galvanisieren, wobei die zuvor ganzflächig aufgebrachte Metallschicht als Elektrode beim Galvanisieren dient, wobei gemäß einer bevorzugten Ausführungsform der Erfindung die Kontakte eine Dicke von ca. 25 $\mu$m aufweisen.

Im folgenden wird die Erfindung anhand einer speziellen Ausführungsform des erfindungsgemäßen Verfahrens näher erläutert. Die zugehörigen Figuren 2a - 2c zeigen eine Halbleiteranordnung bei verschiedenen Stufen des erfindungsgemäßen Verfahrens.

Eine Halbleiteranordnung mit zwei Leitbahnebenen und einer auf der zweiten Leitbahnebene aufgebrachten, Risse und Unterbrechungen aufweisende Isolationsschicht wurde schon anhand der Figur 1a beschrieben und dient im folgenden als Ausgangslage zur Beschreibung des erfindungsgemäßen Verfahrens mit Hilfe der Figuren 2a - 2c. Hierbei sind in diesen Figuren diejenigen Teile, die denen aus den Figuren 1a - 1c entsprechen, mit den gleichen Bezugszeichen versehen.

Der erfindungsgemäße Polyimidprozeß wird nach dem Aufbringen der die zweite Leitbahnebene 5 passivierenden Isolationsschicht 6, die beispielsweise als Plasma-Oxid mit einer Dicke von ca. 1,0 μm abgeschieden wird, durchgeführt. Zuerst wird die Halbleiteranordnung 1 bei einer Temperatur von ca. 200 °C getempert und anschließend ein Haftvermittler aufgeschleudert und getrocknet. Das Polyimid wird durch Aufschleudern auf den Haftvermittler aufgebracht, wobei die Dicke der Polyimidschicht 7 ca. 1,3 μm beträgt. Bevor das Polyimid strukturiert wird, erfolgt eine Polymerisation bei einer Temperatur von ca. 400 °C während einer Dauer von ca. 60 Minuten.

Die Strukturierung der Polyimidschicht 7 erfolgt durch einen Photolackprozeß und einem daran anschließenden Plasmaätzen mit O₂-Gas. Hierdurch werden die Kontaktbereiche 11 (siehe Figur 2a) zur zweiten Leitbahnebene 5 freigelegt. Dieser Strukturierungsprozeß des Polyimids wird durch das Entfernen des Photolackes mit Hilfe eines Lösungsmittels und durch das Trocknen der Polyimidschicht bei 200 °C abgeschlossen. Die Figur 2a zeigt diese Stufe des erfindungsgemäßen Verfahrens.

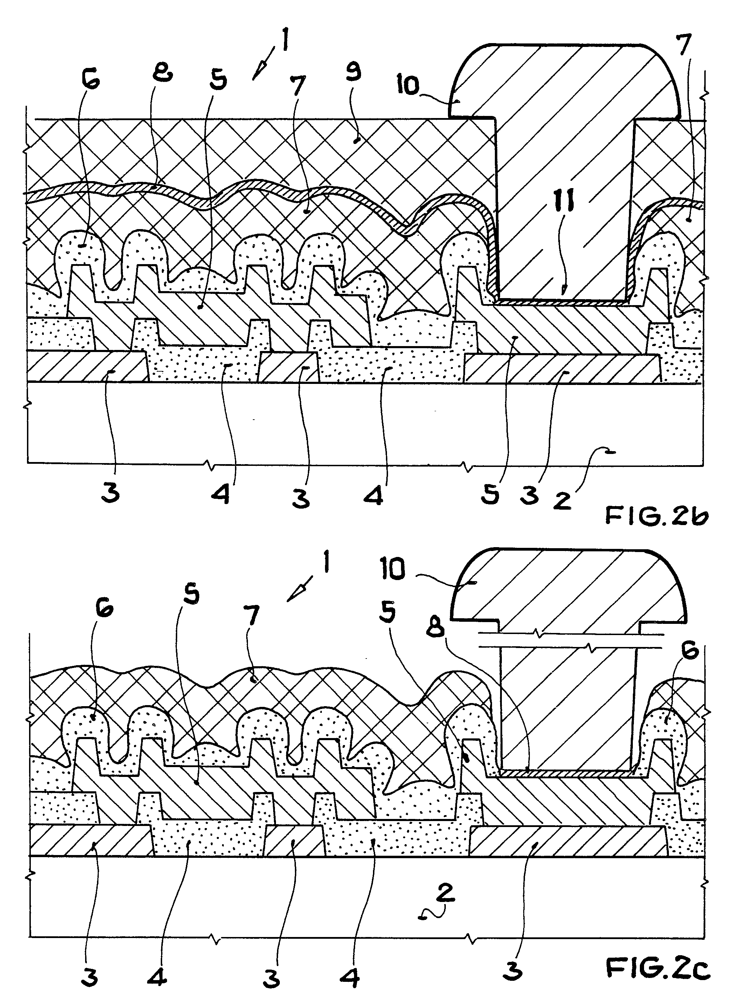

Mit dem ganzflächigen Bedampfen der Polyimidschicht 7 mit Metall wird das erfindungsgemäße Verfahren fortgesetzt, indem eine dünne Metallschicht 8 hergestellt wird, die aus einer Schichtenfolge Titan-Titanwolfram-Gold besteht. Daran anschließend erfolgt die Strukturierung dieser Metallschicht 8, um den Kontaktbereich 11 zu begrenzen. Die Figur 2b zeigt die ganzflächig auf die Polyimidschicht 7 aufgebrachte, ca. 0,5 μ dicke Metallschicht 8 und die Photolackschicht 9, die den Kontaktbereich 11 für die nachfolgende Herstellung des Kontaktes 10 freiläßt. Die Herstellung dieses Kontaktes 10 erfolgt durch Galvanisieren, wobei die Metallschicht 8 als Elektrode dient. Bei diesem Prozeß wächst im Kontaktbereich 11 ein annähernd pilzförmiger Kontakt 10, der beispielsweise aus einer Schichtenfolge Nickel-Gold besteht und eine Dicke von ca. 25 μm aufweist. Die Figur 2b zeigt diese Stufe des erfindungsgemäßen Verfahrens.

Im letzten Prozeßschritt wird der Photolack 9 durch ein Lösungsmittel entfernt. Diesen Zustand zeigt die Figur 2c, aus der auch ersichtlich ist, daß die Polyimidschicht 7 das Ätzmittel daran hindert, in die Risse und Unterbrechungen der darunterliegenden Isolationsschicht 6 zu gelangen, um dort die Leitbahnen 5 der zweiten Leitbahnebene zu beschädigen.

## Ansprüche

1) Verfahren zum Herstellen einer Halbleiteranordnung (1) mit mindestens zwei übereinander angeordneten Leitbahnebenen (3, 5), bei dem nach Herstellung der letzten Leitbahnebene (5) diese mit einer passivierenden Isolationsschicht (6) abgedeckt wird, dadurch gekennzeichnet, daß auf die passivierende Isolationsschicht (6) eine Polyimidschicht (7) aufgebracht wird, daß diese Polyimidschicht (7) zur Freilegung von Kontaktbereichen (11) an die letzte Leitbahnebene (5) strukturiert wird, daß danach ganzflächig eine dünne Metallschicht (8) aufgebracht wird, die in den Kontaktbereichen (11) mit Hilfe eines Photolack-Prozesses und einer nachfolgenden Metallabscheidung zur Bildung von Kontakten (10) verstärkt werden, und daß schließlich die nicht verstärkten Bereiche der dünnen Metallschicht (8) durch Ätzen entfernt werden.

2) Verfahren nach Anspruch 1,. dadurch gekennzeichnet, daß die Polyimidschicht (7) durch Aufschleudern aufgebracht wird.

3) Verfahren nach Anspruch 1 oder 2, dadurch gekennzeichnet, daß die Polyimidschicht (7) eine Dicke zwischen 1,0 und 1,5 μm aufweist.

4) Verfahren nach einem der vorangehenden Ansprüche, dadurch gekennzeichnet, daß die Metallschicht (8) aus einer Schichtenfolge Titan-Titanwolfram-Gold besteht.

5) Verfahren nach einem der vorangehenden Ansprüche, dadurch gekennzeichnet, daß die Metallschicht (8) eine Dicke von ca. 0,5 μm aufweist.

6) Verfahren nach einem der vorangehenden Ansprüche, dadurch gekennzeichnet, daß die Metallschicht (8) durch Sputtern aufgebracht wird.

7) Verfahren nach einem der vorangehenden Ansprüche, dadurch gekennzeichnet, daß die Metallkontakte (10) pilzförmig ausgebildet sind.

8) Verfahren nach einem der vorangehenden Ansprüche, dadurch gekennzeichnet, daß die Metallkontakte (10) aus einer Schichtenfolge Nickel-Gold bestehen.

9) Verfahren nach einem der vorangehenden Ansprüche, dadurch gekennzeichnet, daß die Metallkontakte (10) durch Galvanisieren aufgebracht werden.

10) Verfahren nach einem der vorangehenden Ansprüche, dadurch gekennzeichnet, daß die Metallkontakte (10) eine Dicke von ca. 25 μm aufweisen.

1

6
5
11
5
6

3    4    3    4    3    2    4

**FIG.1a**

1
10
6    8    9
11
6

3    5    4    3    4    5    3    2    4

**FIG.1b**

HN87-35

FIG.1c

FIG.2a

FIG.2b

FIG.2c

| | | Europäisches Patentamt | EUROPÄISCHER RECHERCHENBERICHT | Nummer der Anmeldung |
|---|---|---|---|---|
| | | | | EP 89 10 0416 |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | SIEMENS FORSCHUNGS- UND ENTWICKLUNGSBERICHTE, Band 11, Nr. 4, 1982, Seiten 174-179, Springer Verlag, Würzburg, DE; E. HIEKE: "Resist technology for the metallization of integrated circuits by electron-beam writing" <br> * Figur 13; Seite 178, linke Spalte, Absatz 5.: "Examples of gate array multilayer metallization with negative electron resist" * <br> --- | 1 | H 01 L 21/60 |
| A | THIN SOLID FILMS, Band 93, Nr. 3/4, Juli 1982, Seiten 359-383, Elsevier Sequoia, NL; P.B. GHATE: "Metallization for very-large-scale integrated circuits" <br> * Figur 17; Seite 378, Absatz 6: "Future trends" * <br> --- | 1,4,5, 10 | |
| A | EP-A-0 206 937 (FAIRCHILD) <br> * Zusammenfassung; Figur 2; Seite 10, Zeile 4 - Seite 12, Zeile 6; Figur 3 * <br> ----- | 1,2 | RECHERCHIERTE SACHGEBIETE (Int. Cl.4) <br><br> H 01 L |

Der vorliegende Recherchenbericht wurde für alle Patentansprüche erstellt

| Recherchenort | Abschlußdatum der Recherche | Prüfer |
|---|---|---|
| DEN HAAG | 11-05-1989 | MACHEK,J. |